# EUROPEAN PATENT SPECIFICATION

(11) **EP 4 004 991 B1**
(45) Date of publication and mention of the grant of the patent: **19.06.2024**
(21) Application number: 20764145.7
(22) Date of filing: 22.07.2020
(51) Int. Cl.: H10N 30/30, H02N 2/18

(54) **AN ENERGY HARVESTING SYSTEM, FASTENER, USE, AND METHOD FOR THE CONVERSION OF KINETIC ENERGY INTO ELECTRICAL ENERGY**
ENERGIEGEWINNUNGSSYSTEM, BEFESTIGUNGSMITTEL, VERWENDUNG UND VERFAHREN ZUR UMWANDLUNG VON KINETISCHER ENERGIE IN ELEKTRISCHE ENERGIE
SYSTÈME DE RÉCOLTE D'ÉNERGIE, MOYEN DE FIXATION, UTILISATION ET PROCÉDÉ DE CONVERSION D'ÉNERGIE CINÉTIQUE EN ÉNERGIE ÉLECTRIQUE

(30) Priority: 22.07.2019 IT 201900012564
(43) Date of publication of application: 01.06.2022
(73) Proprietor: SENS-IN S.r.l., 40068 San Lazzaro di Savena (BO) (IT)
(72) Inventor: RAVAGLIA, Simone, 40068 San Lazzaro Di Savena (BO) (IT); PAGANELLI, Mattia, 40068 San Lazzaro Di Savena (BO) (IT)
(74) Representative: Studio Torta S.p.A.
(86) International application number: PCT/IB2020/056904
(87) International publication number: WO 2021/014381

(56) References cited:
- WO-A1-2018/189545
- WO-A2-2012/145279
- CN-A- 109 973 575

## Description

### TECHNICAL FIELD

The present invention relates to an energy harvesting system, a fastener, the use of an energy harvesting system and a method for the conversion of kinetic energy into electrical energy.

In particular, the present invention relates to an energy harvesting system capable of recovering energy from a kinetic source (for example, from vibrations).

Furthermore, the present invention relates to a fastener, in particular a screw, which comprises this type of energy harvesting system, so as to ensure, in addition to the function of joining the components of a mechanical apparatus, the function of converting kinetic energy into electrical energy and, if necessary, storing the latter.

### BACKGROUND ART

The use of fasteners is known, in particular screws, for connecting mechanical components to one another. During use, the fasteners, in particular the screws, are subjected to elevated mechanical stress and they must have elevated mechanical resistance (and often thermal resistance, too) so as to ensure the correct operation, over time, of the mechanical apparatus, in which they are applied.

The fasteners, in particular the screws, are applied in a great number of mechanical apparatuses. The fasteners, in particular the screws, are often installed in positions, which are subjected to elevated vibrations. For example, at a head of a combustion engine, or on aeronautical and aerospace vehicles.

In general, a fastener comprises a shank, which forms the main connection/seal element, depending on the type of tightening element the shank can have a head or it can cooperate with other components, such as: nuts, washers, or similar. Preferably, the fastener is configured to tighten bodies, which are subjected to elevated dynamic stress, i.e. vibrations, and/or thermal stress.

One example of a fastener is the tight screw, which comprises, in addition to the shank, a head, projecting both axially and radially outwards from the shank. In particular, a tight screw is used for tightening the head of a motor and it has a length, i.e. an extension along the longitudinal axis, which is significantly greater than the diameter thereof.

Special fasteners are also known, such as special tight screws, i.e. made of a high-performance material, which is lighter than steel (generally for automotive or aerospace applications)

Preferably, the present invention relates to tightening elements, in particular screws, made of a material with elevated mechanical and thermal resistance, for example, made of titanium alloy.

It is also known to provide sensors installed inside the fasteners; however, such sensors must be electrically powered, therefore, either a battery is provided inside the fastener or, generally, cables are used for connecting the sensors to an external power supply.

Clearly, the solution of the cables has the drawback of having to involve an external supply and, therefore, of being able to use this type of sensorised fasteners mainly in the bench test steps and/or in areas where the fastener is not moving or where it can be reached with a cable.

In other technical fields, the use of technologies that are capable of recovering/storing energy from environmental sources is also known. This includes solar, thermal, wind, and kinetic energy.

Energy harvesting systems are also known, which are capable of converting the kinetic energy into mechanical energy by means of using mechanical oscilloscopes. However, this type of energy harvesting/ conversion system relates to large mechanical apparatuses (for example, wind turbines or systems, which recover energy from wave motion).

Additionally, energy harvesting systems are known, to be applied to mobile devices, as described for example in US2015288299 A1, WO 2012/145279 A2 and WO 2018/189545 A1.

Energy harvesting systems that can be applied to existing mechanical apparatuses, such as cars, planes, or aerospace vehicles, without having to modify the configurations and/or functionality of the same, are not known.

Energy harvesting systems that are configured to be applied inside a fastener, such as a screw, are not known. In other words, energy harvesting systems that are: capable of withstanding the stress to which a fastener is subjected in use; sufficiently miniaturised for ensuring adequate mechanical resistance of the fastener (without weakening it too much); and ensuring a significant electrical energy storage/harvesting (i.e. which justifies the use thereof in terms of cost/benefits), are not known.

### DISCLOSURE OF INVENTION

It is one purpose of the present invention to provide an energy harvesting system that can be used in mechanical components of limited dimensions, such as fasteners, and that can be subjected to elevated mechanical and thermal stress.

It is one purpose of the present invention to provide a fastener, in particular a screw or similar, capable of ensuring adequate mechanical resistance (for fulfilling the main purpose thereof of joining) and, at the same time, which is capable of recovering electrical energy, for reusing and/or storing, from kinetic phenomena, to which the fastener is subjected in use.

According to the present invention, an energy harvesting system is provided, as stated in the attached claims.

According to the present invention, a fastener is provided, as stated in the attached claims.

According to the present invention, the use of an energy harvesting system is provided, as stated in the attached claims.

According to the present invention, a method is provided for harvesting energy, as stated in the attached claims.

### BRIEF DESCRIPTION OF THE DRAWINGS

The present invention will now be described with reference to the attached drawings, illustrating a nonlimiting embodiment thereof:
- Figure 1 is a partially sectional side view of a fastener according to the present invention;
- Figure 2 is a plan view of the fastener in Figure 1;
- Figure 3 is a partially sectional side view of a variation of the fastener according to the present invention;
- Figure 4 is a schematic view of a harvesting system according to the present invention;
- Figure 5 is a perspective and schematic view of a variation of the harvesting system according to the present invention;
- Figures 6 and 7 are a side view and a perspective view respectively, with parts removed for clarity, of a variation of a harvesting system according to the present invention;
- Figures 8 and 9 are a side view and a perspective view respectively, with parts removed for clarity, of a variation of a harvesting system according to the present invention; and
- Figures 10 and 11 are a side view and a perspective view respectively, with parts removed for clarity, of a variation of a harvesting system according to the present invention;
- Figures 12 to 14 are examples of a detail of a harvesting system according to the present invention.

### BEST MODE FOR CARRYING OUT THE INVENTION

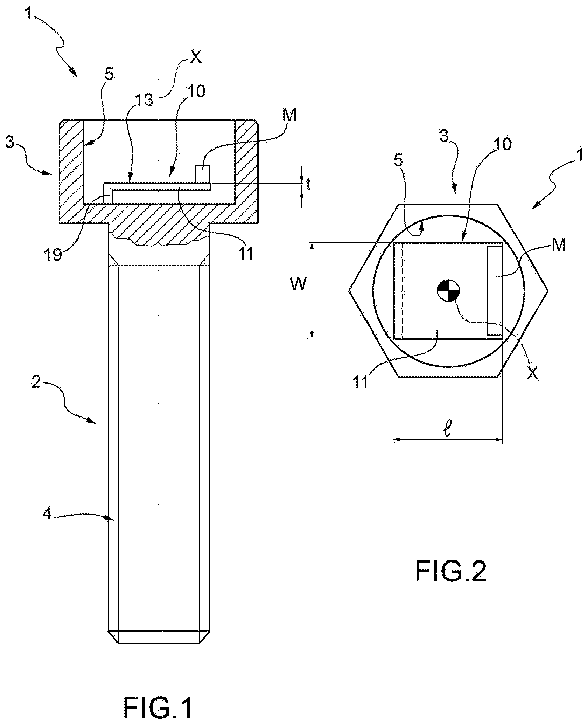

In Figure 1, a fastener 1 according to the present invention is globally denoted with 1.

Advantageously, a fastener 1 is configured to connect two or more mechanical components to one another and to withstand elevated mechanical and thermal stress.

Without loss of generality, as mentioned previously, the technical solution concerns any type of fastener 1.

Advantageously, the fastener 1 is configured to withstand elevated temperatures, in particular temperatures greater than the melting point of steel, such as temperatures greater than 1300 °C.

Advantageously, the fastener 1 is made of a material with high mechanical resistance.

Advantageously, the fastener 1 is made, at least partially, of a material selected from the following group of materials: titanium, titanium alloys; nickel-chrome alloys generally known as INCONEL^{®}; stainless steel X1CrNiMoAlTi12-11-2 generally known as MLX17^{®}; stainless steel X1NiCrMoAlTi12-10-2 generally known as MLX19^{®}; and stainless steels class PH (Precipitation Hardening) ranging between 13-8 or 15-5 or 17-4; Steel with composition Si, 19.00-21.00 Cr, 33.00-37.00 Ni, 9.00-11.00 Mo, 1.00 max. Ti, 0.01 B, 1.00 max Fe, Bal Co generally known as MP35N^{®}; steels comprising nickel and cobalt generally known as MARAGING^{®} and/or VASCOMAX^{®}, for example, MARAGING300 or AERMET^{®}100; steels AISI4340, AFNOR30NiCrMo16 and stainless series AISI300 and series AISI400.

In Figure 1, a screw 1, comprising a shank 2 and a head 3, is globally schematised as an example of a fastener 1. The screw 1 has a longitudinal rotation axis X and a threaded portion 4 made on the outer surface of the shank 2.

For example, the screw 1 can be a tight screw having a length greater than 150 or 200 mm, preferably about 300 mm.

According to a variation, which is not illustrated, the screw can be made up of a plurality of components, which are tightened and locked to one another, so as to form a single body. In other words, according to a variation, which is not illustrated, the fastener 1, in particular a screw 1 may not be a single monolithic piece. For example, the screw can comprise a shank and a nut tightened and locked to each other, so as to form a single body. As said previously, the fastener 1 according to the present invention can be different from the screw, for example, it can be a bolt, a rod, a stud, a rivet, or the like.

Advantageously, the fastener 1 comprises an energy harvesting system 10, which is configured to recover energy from kinetic phenomena, to which the fastener 1 is subjected in use.

According to the example in Figures 1 and 2, the screw has a housing 5 in the head 3 and the energy harvesting system 10 is inserted inside the head 3 of the screw.

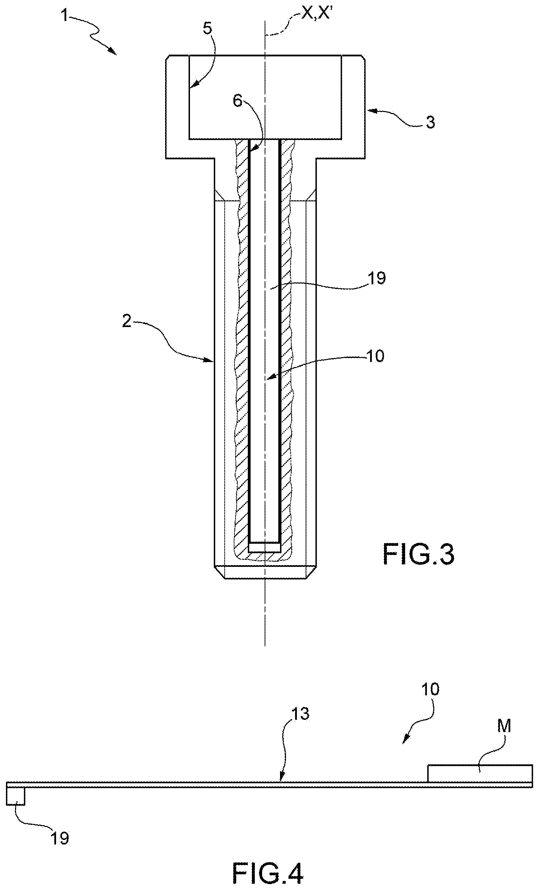

According to the variation shown in Figure 3, the screw has a cavity, which extends along the shank 2 and the harvesting system 10 is inserted inside the shank 2.

Advantageously, the harvesting system 10 comprises a sensitive element 11, and a mass M.

The sensitive element 11 is configured to convert the kinetic energy, which hits it, into a potential difference. In other words, the sensitive element 11 is configured to convert the kinetic energy into electrical energy. Advantageously, the harvesting system 10 is of the piezoelectrical type.

Advantageously, the sensitive element 11 comprises at least a part made of a piezoelectrical material. A piezoelectrical material is known to generate a charge imbalance on the faces thereof when it is subjected to a force/is deformed. The sensitive element 11 comprises a piezoelectrical transducer 13.

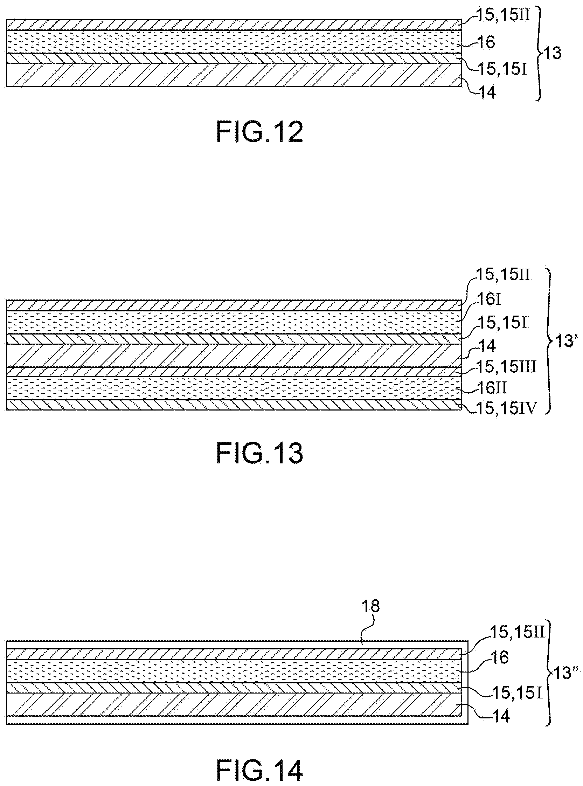

Sections of known structures of piezoelectrical transducers 13 are schematically illustrated in Figures 12 to 14.

A piezoelectrical transducer 13 generally comprises a wafer structure consisting, in order, of the following sequence of components:
- a substrate 14;
- an electrode 15I;
- a piezoelectrical material layer 16;
- an additional electrode 15II.

Advantageously, the substrate 14 is made of an elastic material in this way the piezoelectrical transducer 13, in turn, has a good elasticity.

Advantageously, the substrate 14 is made, at least partially, of: brass and/or carbon fibre and/or stainless steel and/or non-magnetic material, such as brass with silver.

The piezoelectrical material layer 16 can be made of an inorganic and/or organic material. The inorganic substrate 14 can comprise single- or multi-layer ceramic. The piezoelectrical material layer 16 can comprise one or more of these materials: PZT, ZnO, SnO, PVDF, P(VDF-FrFE), or other equivalent materials.

In the case of deforming an illustrated piezoelectrical transducer 13, a potential difference is generated between the two electrodes 15, so as to generate electrical energy as a result.

Advantageously, the fact that the piezoelectrical transducer 13 is made of an elastic material allows the piezoelectrical transducer 13 to vibrate naturally when it is subjected to an external force. This allows the generation of the electrical energy to be prolonged over time, including upon cessation of the external force that generated the activation of the piezoelectrical transducer 13.

Another variant of the piezoelectrical transducer 13 is shown in Figure 13. In the illustrated example, in addition to the previously described base composition, the piezoelectrical transducer 13 comprises a wafer structure that comprises, in addition to the previous description, the following sequence of components as well:
- an electrode 15III;
- a piezoelectrical material layer 16II;
- another electrode 15IV.

The electrodes 15 are at least partially made of an electrically conductive material. The electrodes 15 can be connected to each other in series or parallel.

According to the variant shown in Figure 14 the piezoelectrical transducer 13 can have a coating 18 made of an insulating material. The insulating material can be electrically and/or thermally and/or impermeably insulating.

Advantageously, the substrate 14 has an elastic modulus greater than 90 GPa, preferably smaller than 120 GPa.

Advantageously, the substrate 14 has a work temperature that is greater than 600°C, preferably ranging from 700°C to 1400°C.

Therefore, a substrate 14 of this type lends itself to an application, in which the piezoelectrical transducer 13 is subjected to elevated and frequent vibrations. Furthermore, the value of the density greater than 5 g/cm³, in particular greater than 6 g/cm³, preferably greater than 8 g/cm³, allows wider oscillations to be obtained and, consequently, a greater deformation of the piezoelectrical material layer 16 in use.

When an external force causes the deformation, in particular the vibration, of the piezoelectrical material layer 16 of a piezoelectrical transducer 13 of the type described above, a difference in voltage is generated, in a known manner, between the electrodes 15.

Advantageously, according to the present invention, the energy harvesting system 10 also comprises an anchoring system 19 for being fixed, in use, to the fastener 1.

According to the example shown in Figure 1, the anchoring system 19 is a base that is fixed (for example, by gluing or welding) in the housing 5 of the head 3.

The sensitive element 11 is substantially plate-shaped with a length l, width w (shown in Figure 2) and thickness t (Figure 1). The sensitive element 11 is fixed to the anchoring system 19 in a cantilever fashion, so as to be able to move, in particular oscillate, in use, with respect to the body of the fastener 1. According to the illustrated example, the sensitive element 11 has a basically squared plan shape. The sensitive element 11 is connected to the anchoring system 19 along one side.

According to the example shown in Figures 1 and 2, the anchoring system 19 is configured to keep the sensitive element 11 raised in a cantilever fashion inside the housing 5 of the screw, so that during the vibrations the sensitive element 11 doesn't knock against the fastener 1. Advantageously, the mass M is fixed to the sensitive element 11 along the side opposite the one for connecting to the anchoring system 19.

The schematic form of a first embodiment of the harvesting system 10, according to the present invention, is shown in Figure 4.

The shape and size of the mass M are a function of the type of application of the fastener 1 and they are configured so as to obtain the greatest number of vibrations possible and with the greatest breadth possible during normal use of the fastener 1.

Advantageously, the mass M has a density, which is greater than 5 g/cm³ in particular greater than 6 g/cm³, preferably greater than 8 g/cm³.

According to a variant, which is not shown, the energy harvesting system 10 can comprise a different number of masses M, for example, it can have two masses M applied in different positions to the sensitive element 11.

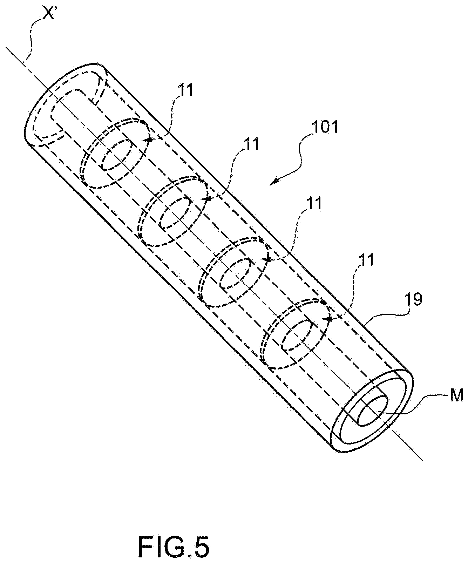

In the variant shown in Figure 3, the harvesting system 10 is inserted inside the shank 2 of the fastener 1. Different possible variants of the harvesting system 10, according to the present invention, are shown in Figures 5 to 11.

A variation of the harvesting system 10 is indicated in Figure 5 with 101, according to the invention, the anchoring system 19 is a tubular body, in particular with a circular section with a longitudinal axis X', and it has an inner sliding channel 20. Furthermore, the mass M has a substantially cylindrical shape and is inserted inside the anchoring system 19. In particular, the mass M is cylindrical shaped and substantially coaxial to the longitudinal axis X' . The anchoring system 19 comprises a plurality of sensitive elements 11, each of which has a disc shape and is fitted around the mass M.

Advantageously, the sensitive elements 11 are configured so that, in use, the mass M can slide longitudinally inside the anchoring system 19. Advantageously, the sensitive elements 11 can be fixed either to the anchoring system 19 or to the mass M. If necessary, some sensitive elements 11 are fixed to the mass M, while other flexible elements 11 are fixed to the anchoring system 19.

Advantageously, in use, the mass M moves inside the anchoring system 19, causing the deformation of the sensitive elements 11.

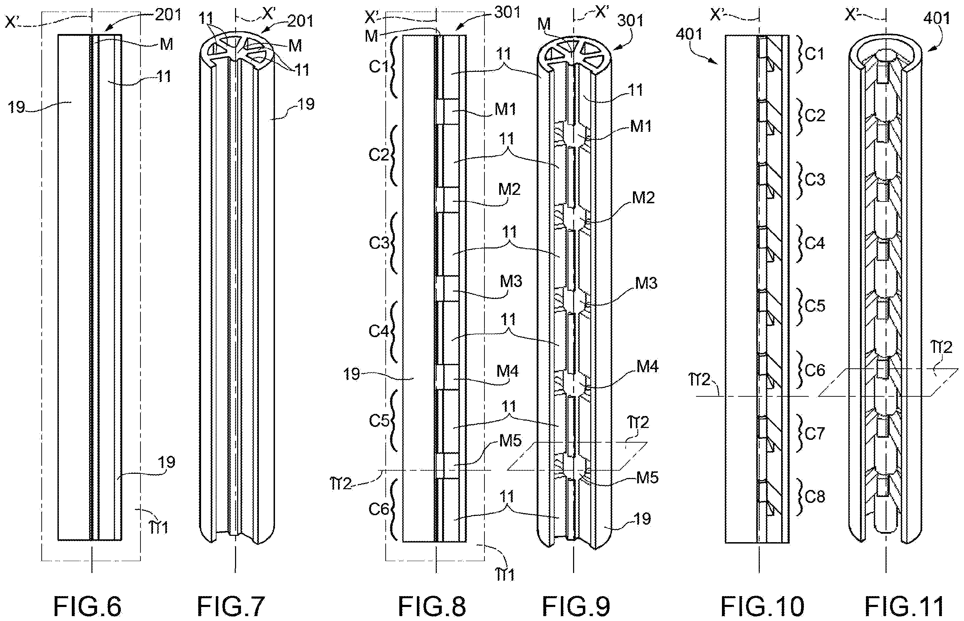

A variant of the harvesting system 10 is illustrated in Figures 6 and 7 with 201. According to the solution illustrated in Figures 6 and 7, the anchoring system 19 is formed from a tubular body with a circular section with a longitudinal axis X' and it has an inner sliding channel 20. Furthermore, the mass M has a substantially cylindrical shape, it is inserted inside the anchoring system 19, and it is substantially coaxial to the longitudinal axis X'. The anchoring system 19 comprises a plurality of sensitive elements 11, each sensitive element 11 has the shape of a plate, projecting radially from the mass M.

The set of all of the sensitive elements 11 substantially forms a radial structure, interposed between the mass M and the anchoring system 19. Advantageously, the sensitive elements 11 are connected to the mass M or to the anchoring system 19. According to the illustrated example, the sensitive elements 11 have a longitudinal extension, which is substantially equal to the longitudinal extension of the anchoring system 19.

A variant of the harvesting system 10, according to the present invention, is illustrated in Figures 8 and 9 with 301.

The solution illustrated in Figures 8 and 9 is similar to the solution described in Figures 6 and 7 and differs from the latter in that it involves a plurality of sensitive elements 11 with a smaller extension than the longitudinal extension of the anchoring system 19.

Therefore, advantageously, the radial distribution of the sensitive elements 11 around the mass M is axially spaced apart. In particular, according to what is illustrated in Figures 8 and 9, the harvesting system 10 comprises a plurality of rings C of sensitive elements 11, each ring C is axially spaced apart from an adjacent ring C by a mass M. Advantageously, according to this technical solution, depending on the type of application of the fastener 1, it is possible to vary the entity of the mass M, so as to obtain the best resonance of the harvesting system 10, in response to the external agents.

An additional variant of the harvesting system 10, according to the present invention, is shown in Figures 10 and 11 with 401. Unlike the solution described in Figures 9 and 10, each sensitive element 11 is inclined with respect to a plane π2 perpendicular to the longitudinal axis X' of the anchoring system 19. In this case, too, the rings C of adjacent sensitive elements are spaced apart from one another by a mass M.

Advantageously, energy harvesting systems 101, 201, 301, 401 of the type described above are inserted inside the cavity in the shank 2 of the screw so as to be substantially coaxial to the longitudinal axis X of the shank 2. The material with which it is made and/or the dimensions of the anchoring system 19 allow an interference coupling to be created inside the cavity 6 of the fastener 1. Alternatively, the anchoring system 19 is fixed inside the cavity 6 by means of intermediate bodies, for example, by means of gluing or locking elements (not shown).

Advantageously, the fact that the anchoring system 19 has a tubular body, in particular with a circular section, facilitates operations of insertion and assembly of energy harvesting systems inside the cavity 6 of the fastener 1. Advantageously, the presence of the tubular anchoring system 19 allows the energy harvesting system 10 to be positioned with a certain inclination with respect to the longitudinal axis X of the fastener 1. According to the illustrated examples, the harvesting systems 101, 201, 301, 401 are coaxial to the longitudinal axis X of the fastener 1. Therefore, it is possible to predetermine the extension and orientation of the vibrations of the masses.

According to a variant, which is not shown, the body of the fastener 1, i.e. according to the illustrated example the body of the screw directly forms the anchoring system 19 of the harvesting system 10. In this case, inside the body of the fastener 1 housings and/or cavities are present, capable of interfering and retaining the sensitive elements 11 or the mass M of the harvesting system 10.

In use, a harvesting system 10, 101, 201, 301, 401 of the type described above is installed on a fastener 1, for example, a screw. For example, it is inserted inside a housing 5 in the head 3 of the screw or inside a cavity in the shank 2 of the screw.

Thus, the harvesting system 10, 101, 201, 301, 401 can be connected to an electric circuit inside the fastener 1 (not shown). For example, the fastener 1 can be provided with sensors and the harvesting system 10 is connected to the sensors so as to supply them with electrical energy. Additionally, or alternatively, the fastener 1 can be provided with a storage unit (not shown) for storing the electrical energy produced.

Advantageously, the harvesting system 10, 101, 201, 301, 401 of the type described above can be miniaturised and inserted inside mechanical components that have limited dimensions, such as the fasteners 1, in particular the screws.

Advantageously, the fact of comprising an energy harvesting system 10, 101, 201, 301, 401 inside known fasteners 1 such as screws, allows energy harvesting systems 10, 101, 201, 301, 401 to be installed inside pre-existing complex mechanical apparatuses, exploiting the existing housings for traditional fasteners. This allows energy to be implemented and recovered from the vibrations of existing mechanical apparatuses without their having to be redesigned, ensuring the same (improved) functionality thereof.

Advantageously, it is possible to provide a plurality of fasteners on board the same mechanical apparatus, each of which is provided with a respective energy harvesting system. Thus, on board existing mechanical apparatus, it is also possible to provide a plurality of different areas for the local recovery of kinetic energy and the conversion thereof into electrical energy. In a known manner, the fasteners 1 of the same mechanical apparatus can be connected to an external electric circuit or to one or more storage units (batteries).

## Claims

1. An energy harvesting system comprising:
- one or more sensitive elements (11) comprising at least one layer made of a piezoelectrical material;
- a mass (M);
- an anchoring system (19), which is configured to cooperate, in use, with said mass (M) so as to at least partially deform said sensitive element (11);
wherein each sensitive element (11) comprises:
- a substrate (14);
- a first electrode (15);
- a piezoelectrical material layer (16);
- a second electrode (15);
wherein the substrate (14) is at least partially made of a material having an elastic modulus greater than 90 GPa, preferably smaller than 120 GPa;
**characterized in that**, said anchoring system (19) is a tubular body having a longitudinal axis (X') and an inner sliding channel (20); wherein said mass (M) is mounted so as to move inside said inner sliding channel (20); wherein the harvesting system (101; 201; 301; 401) comprises a plurality of sensitive elements (11) interposed between said mass (M) and the anchoring system (19) so as to be deformed, in use, by the relative movement between said mass (M) and said anchoring system (19).

2. The energy harvesting system according to claim 1 and comprising a mass (M), which is connected to the sensitive element (11).

3. The energy harvesting system according to any of the preceding claims, wherein each sensitive element (11) is a disc, which is fitted around said mass (M).

4. The energy harvesting system according to any of the preceding claims, wherein each sensitive element (11) is a plate, which is substantially parallel to a plane (π2), which is perpendicular to the longitudinal axis (X') of the anchoring system (19); wherein each sensitive element (11) radially projects outwards from the mass (M).

5. The energy harvesting system according to any of the preceding claims, wherein each sensitive element (11) is a plate, which is radial to the mass (M) and substantially parallel to a plane (π1), which includes the longitudinal axis (X') of the anchoring system (19); wherein said mass (M) and each plate have a longitudinal extension, which is substantially equal to the longitudinal extension of said anchoring system (19).

6. The energy harvesting system according to any of the preceding claims, wherein each sensitive element (11) is a plate, which is radial to the mass (M) and substantially parallel to a plane (π1), which includes said longitudinal axis (X'); wherein said mass (M) and each plate have a longitudinal extension, which is smaller than the one of the anchoring system (19); said energy harvesting system (101; 201; 301; 401) having a plurality of rings (C) of sensitive elements (11) arranged radially relative to the mass (M); wherein between two adjacent rings (C) there is interposed a further mass (M), whose extent is a function of a predefined resonance frequency.

7. The energy harvesting system according to claim 5, wherein each sensitive element (11) is a plate, which is inclined relative to a plane (π2), which is perpendicular to the longitudinal axis (X').

8. The energy harvesting system according to any of the preceding claims, wherein the extent of the mass (M) along said longitudinal axis (X') is variable depending on a predefined resonance frequency.

9. The energy harvesting system according to one of the preceding claims, wherein the mass (M) has a density, which is greater than 5 g/cm³, in particular greater than 6 g/cm³, preferably greater than 8 g/cm³.

10. The energy harvesting system according to one of the preceding claims, wherein the substrate (14) has a work temperature that is greater than 600°C, preferably ranging from 700°C to 1400°C.

11. A fastener, in particular a screw comprising an energy harvesting system (10; 101; 201; 301; 401) according to one of the preceding claims.

12. The fastener according to claim 11 and comprising a shank (2) having a longitudinal axis (X) and an inner cavity (6); wherein said energy harvesting system (101; 201; 301; 401) is inserted inside said inner cavity (6); wherein the body of the fastener (1) makes up said anchoring system (19) of the energy harvesting system (101; 201; 301; 401) or said anchoring system (19) is fixed inside the cavity (6) of the fastener (1).

13. A use of an energy harvesting system (10; 101; 201; 301; 401) according to one of claims 1 to 10 in a fastener (1), in particular a screw.

14. A method for the conversion of kinetic energy into electrical energy by means of an energy harvesting system (10; 101; 201; 301; 401) according to one of claims 1 to 10, the method comprising the steps of: installing an energy harvesting system (10; 101; 201; 301; 401) according to one of claims 1 to 11 in a fastener (1), in particular a screw; installing said fastener (1) on a mechanical apparatus; converting the kinetic energy, in particular the vibrations, of said mechanical apparatus into electrical energy at said fastener (1) by means of said energy harvesting system (10; 101; 201; 301; 401).

15. The method according to claim 14 and comprising the step of installing a plurality of harvesting systems (10; 101; 201; 301; 401) each one inside a respective fastener (1) and installing each fastener (1) on a mechanical apparatus in respective different areas; converting the kinetic energy, in particular the vibrations, of said mechanical apparatus into electrical energy at each fastener (1) by means of a respective energy harvesting system (10; 101; 201; 301; 401); storing and/or reusing the kinetic energy produced by each fastener (1) in a storage unit or in an electric circuit.

## Patentansprüche

1. Ein Energiegewinnungssystem , umfassend:
- ein oder mehrere empfindliche Elemente (11) umfassend mindestens eine Schicht aus einem piezoelektrischen Material;
- eine Masse (M);
- ein Verankerungssystem (19), das so konfiguriert ist, dass es im Gebrauch mit der Masse (M) zusammenwirkt, um das empfindliche Element (11) zumindest teilweise zu verformen; wobei jedes empfindliche Element (11) umfasst:
- ein Substrat (14);
- ein erste Elektrode (15);
- ein piezoelektrische Materialschicht (16);
- ein zweite Elektrode (15);
wobei das Substrat (14) zumindest teilweise aus einem Material mit einem Elastizitätsmodul von mehr als 90 GPa, vorzugsweise kleiner als 120 GPa, besteht; **dadurch gekennzeichnet, dass** das besagte Verankerungssystem (19) ein rohrförmiger Körper mit einer Längsachse (X') und einem inneren Gleitkanal (20) ist; wobei besagte Masse (M) so montiert ist, dass sie sich innerhalb des inneren Gleitkanals (20) bewegt; wobei das Gewinnungssystem (101; 201; 301; 401) ein Vielzahl empfindlicher Elemente (11) umfasst, die zwischen der Masse (M) und dem Verankerungssystem (19) angeordnet sind, um im Gebrauch durch die relative Bewegung zwischen der Masse (M) und dem Verankerungssystem (19) verformt zu werden.

2. Das Energiegewinnungssystem nach Anspruch 1 und umfassend eine Masse (M), die mit dem empfindlichen Element (11) verbunden ist.

3. Das Energiegewinnungssystem nach einem der vorhergehenden Ansprüche, wobei jedes empfindliche Element (11) eine Scheibe ist, die um die Masse (M) herum angebracht ist.

4. Das Energiegewinnungssystem nach einem der vorhergehenden Ansprüche, wobei jedes empfindliche Element (11) eine Platte ist, die im Wesentlichen parallel zu einer Ebene (n2) liegt, die senkrecht zur Längsachse (X') des Verankerungssystems (19) verläuft; wobei jedes empfindliche Element (11) radial von der Masse (M) nach außen vorsteht.

5. Das Energiegewinnungssystem nach einem der vorhergehenden Ansprüche, wobei jedes empfindliche Element (11) eine Platte ist, die radial zu der Masse (M) und im Wesentlichen parallel zu einer Ebene (n1) liegt, die die Längsachse (X') des Verankerungssystems (19) enthält; wobei die Masse (M) und jede Platte eine Längserstreckung haben, die im Wesentlichen gleich der Längserstreckung des Verankerungssystems (19) ist.

6. Das Energiegewinnungssystem nach einem der vorhergehenden Ansprüche, wobei jedes empfindliche Element (11) eine Platte ist, die radial zur Masse (M) und im Wesentlichen parallel zu einer Ebene (n1) ist, die die Längsachse (X') enthält; wobei die Masse (M) und jede Platte eine Längserstreckung haben, die kleiner ist als die des Verankerungssystems (19); wobei das Energiegewinnungssystem (101; 201; 301; 401) eine Vielzahl von Ringen (C) aus empfindlichen Elementen (11) aufweist, die radial zur Masse (M) angeordnet sind; wobei zwischen zwei benachbarten Ringen (C) eine weitere Masse (M) angeordnet ist, deren Ausdehnung eine Funktion einer vordefinierten Resonanzfrequenz ist.

7. Das Energiegewinnungssystem nach Anspruch 5, wobei jedes sensitive Element (11) eine Platte ist, die gegenüber einer Ebene (n2), die senkrecht zur Längsachse (X') steht, geneigt ist.

8. Das Energiegewinnungssystem nach einem der vorhergehenden Ansprüche, wobei die Ausdehnung der Masse (M) entlang der Längsachse (X') in Abhängigkeit von einer vorgegebenen Resonanzfrequenz variabel ist.

9. Das Energiegewinnungssystem nach einem der vorhergehenden Ansprüche, wobei die Masse (M) eine Dichte aufweist, die größer als 5 g/cm³, insbesondere größer als 6 g/cm³, vorzugsweise größer als 8 g/cm³ ist.

10. Das Energiegewinnungssystem nach einem der vorhergehenden Ansprüche, wobei das Substrat (14) eine Arbeitstemperatur aufweist, die größer als 600°C ist, vorzugsweise im Bereich von 700°C bis 1400°C.

11. Ein Befestigungselement, insbesondere Schraube, umfassend ein Energiegewinnungssystem (10; 101; 201; 301; 401) nach einem der vorangehenden Ansprüche.

12. Das Befestigungselement nach Anspruch 11 und umfassend einen Schaft (2) mit einer Längsachse (X) und einem inneren Hohlraum (6); wobei das Energiegewinnungssystem (101; 201; 301; 401) in den inneren Hohlraum (6) eingesetzt ist; wobei der Körper des Befestigungselements (1) das Verankerungssystem (19) des Energiegewinnungssystems (101; 201; 301; 401) bildet oder das Verankerungssystem (19) innerhalb des Hohlraums (6) des Befestigungselements (1) befestigt ist.

13. Verwendung eines Energiegewinnungssystems (10; 101; 201; 301; 401) nach einem der Ansprüche 1 bis 10 in einem Befestigungselement (1), insbesondere einer Schraube.

14. Verfahren zur Umwandlung von kinetischer Energie in elektrische Energie mittels eines Energiegewinnungssystems (10; 101; 201; 301; 401) nach einem der Ansprüche 1 bis 10, wobei das Verfahren die Schritte umfasst: Installieren eines Energiegewinnungssystems (10; 101; 201; 301; 401) nach einem der Ansprüche 1 bis 11 in einem Befestigungselement (1), insbesondere einer Schraube; Installieren des Befestigungselements (1) an einer mechanischen Vorrichtung; Umwandeln der kinetischen Energie, insbesondere der Vibrationen, der mechanischen Vorrichtung in elektrische Energie an dem Befestigungselement (1) mittels des Energiegewinnungssystems (10; 101; 201; 301; 401).

15. Verfahren nach Anspruch 14 und umfassend den Schritt des Einbaus einer Vielzahl von Gewinnungssystemen (10; 101; 201; 301; 401) jeweils eins in entsprechende Befestigungselemente (1), und des Einbaus jedes Befestigungselements (1) an einer mechanischen Vorrichtung in jeweils unterschiedlichen Bereichen; Umwandeln der kinetischen Energie, insbesondere der Vibrationen, der mechanischen Vorrichtung in elektrische Energie an jedem Befestigungselement (1) mittels eines jeweiligen Energiegewinnungssystems (10; 101; 201; 301; 401); Speichern und/oder Wiederverwenden der kinetischen Energie, die von jedem Befestigungselement (1) erzeugt wird, in einer Speichereinheit oder in einem Stromkreis.

## Revendications

1. Système de récupération d'énergie comprenant :
- un ou plusieurs éléments sensibles (11) comprenant au moins une couche constituée de matériau piézoélectrique ;
- une masse (M) ;
- un système d'ancrage (19), qui est configuré pour coopérer, en cours d'utilisation, avec ladite masse (M) de manière à déformer au moins partiellement ledit élément sensible (11) ;
dans lequel chaque élément sensible (11) comprend :
un substrat (14) ;
- une première électrode (15) ;
- une couche de matériau piézoélectrique (16) ;
- une seconde électrode (15) ;
dans lequel le substrat (14) est au moins partiellement constitué d'un matériau dont le module d'élasticité est supérieur à 90 GPa, de préférence inférieur à 120 GPa ;
**caractérisé en ce que** ledit système d'ancrage (19) est un corps tubulaire ayant un axe longitudinal (X') et un canal de glissement intérieur (20) ; dans lequel ladite masse (M) est montée de manière à se déplacer à l'intérieur dudit canal de glissement intérieur (20) ; dans lequel le système de récupération (101 ; 201 ; 301 ; 401) comprend une pluralité d'éléments sensibles (11) interposés entre ladite masse (M) et le système d'ancrage (19) de manière à être déformés, en cours d'utilisation, par le mouvement relatif entre ladite masse (M) et ledit système d'ancrage (19).

2. Système de récupération d'énergie selon la revendication 1 et comprenant une masse (M), qui est reliée à l'élément sensible (11).

3. Système de récupération d'énergie selon l'une quelconque des revendications précédentes, dans lequel chaque élément sensible (11) est un disque, qui est monté autour de ladite masse (M).

4. Système de récupération d'énergie selon l'une quelconque des revendications précédentes, dans lequel chaque élément sensible (11) est une plaque, qui est sensiblement parallèle à un plan (π2), qui est perpendiculaire à l'axe longitudinal (X') du système d'ancrage (19) ; dans lequel chaque élément sensible (11) fait saillie radialement vers l'extérieur de la masse (M).

5. Système de récupération d'énergie selon l'une quelconque des revendications précédentes, dans lequel chaque élément sensible (11) est une plaque, qui est radiale par rapport à la masse (M) et sensiblement parallèle à un plan (π1), qui comprend l'axe longitudinal (X') du système d'ancrage (19) ; dans lequel ladite masse (M) et chaque plaque ont une extension longitudinale, qui est sensiblement égale à l'extension longitudinale dudit système d'ancrage (19) .

6. Système de récupération d'énergie selon l'une quelconque des revendications précédentes, dans lequel chaque élément sensible (11) est une plaque, qui est radiale par rapport à la masse (M) et sensiblement parallèle à un plan (π1), qui comprend ledit axe longitudinal (X') ; dans lequel ladite masse (M) et chaque plaque ont une extension longitudinale, qui est plus inférieure à celle du système d'ancrage (19) ; ledit système de récupération d'énergie (101 ; 201 ; 301 ; 401) comportant une pluralité d'anneaux (C) d'éléments sensibles (11) disposés radialement par rapport à la masse (M) ; dans lequel entre deux anneaux adjacents (C) est interposée une autre masse (M), dont l'étendue est fonction d'une fréquence de résonance prédéfinie.

7. Système de récupération d'énergie selon la revendication 5, dans lequel chaque élément sensible (11) est une plaque qui est inclinée par rapport à un plan (π2), qui est perpendiculaire à l'axe longitudinal (X').

8. Système de récupération d'énergie selon l'une quelconque des revendications précédentes, dans lequel l'étendue de la masse (M) le long dudit axe longitudinal (X') est variable en fonction d'une fréquence de résonance prédéfinie.

9. Système de récupération d'énergie selon l'une des revendications précédentes, dans lequel la masse (M) a une densité qui est supérieure à 5 g/cm³, en particulier supérieure à 6 g/cm³, de préférence supérieure à 8 g/cm³.

10. Système de récupération d'énergie selon l'une des revendications précédentes, dans lequel le substrat (14) a une température de travail qui est supérieure à 600°C, de préférence dans la plage de 700°C à 1400°C.

11. Elément de fixation, en particulier une vis, comprenant un système de récupération d'énergie (10 ; 101 ; 201 ; 301 ; 401) selon l'une des revendications précédentes.

12. Elément de fixation selon la revendication 11 et comprenant une tige (2) ayant un axe longitudinal (X) et une cavité intérieure (6) ; dans lequel ledit système de récupération d'énergie (101 ; 201 ; 301 ; 401) est inséré dans ladite cavité intérieure (6) ; dans lequel le corps de l'élément de fixation (1) constitue ledit système d'ancrage (19) du système de récupération d'énergie (101 ; 201 ; 301 ; 401) ou ledit système d'ancrage (19) est fixé à l'intérieur de la cavité (6) de l'élément de fixation (1) .

13. Utilisation d'un système de récupération d'énergie (10 ; 101 ; 201 ; 301 ; 401) selon l'une des revendications 1 à 10 dans un élément de fixation (1), en particulier une vis.

14. Procédé de conversion d'énergie cinétique en énergie électrique au moyen d'un système de récupération d'énergie (10 ; 101 ; 201 ; 301 ; 401) selon l'une des revendications 1 à 10, le procédé comprenant les étapes suivantes : l'installation d'un système de récupération d'énergie (10 ; 101 ; 201 ; 301 ; 401) selon l'une des revendications 1 à 11 dans un élément de fixation (1), en particulier une vis ; l'installation dudit élément de fixation (1) sur un appareil mécanique ; la conversion de l'énergie cinétique, en particulier les vibrations, dudit appareil mécanique en énergie électrique au niveau dudit élément de fixation (1) au moyen dudit système de récupération d'énergie (10 ; 101 ; 201 ; 301 ; 401) .

15. Procédé selon la revendication 14 et comprenant l'étape d'installation d'une pluralité de systèmes de récupération (10 ; 101 ; 201 ; 301 ; 401) chacun à l'intérieur d'un élément de fixation (1) respectif et l'installation de chaque élément de fixation (1) sur un appareil mécanique dans des zones respectives différentes ; la conversion de l'énergie cinétique, en particulier les vibrations, dudit appareil mécanique en énergie électrique au niveau de chaque élément de fixation (1) au moyen d'un système de récolte d'énergie respectif (10 ; 101 ; 201 ; 301 ; 401) ; stocker et/ou réutiliser l'énergie cinétique produite par chaque élément de fixation (1) dans une unité de stockage ou dans un circuit électrique.
